# EUROPÄISCHE PATENTSCHRIFT

(11) **EP 3 589 090 B1**
(45) Veröffentlichungstag und Bekanntmachung des Hinweises auf die Patenterteilung: **12.05.2021**
(21) Anmeldenummer: 19181708.9
(22) Anmeldetag: 21.06.2019
(51) Int. Cl.: H05K 1/18, H01H 71/12, H01H 71/74, H05K 3/34

(54) **SICHERHEITSSCHALTGERÄT MIT VERSENKTEN EINSTELLBAUELEMENTEN**
SAFETY SWITCHING DEVICE WITH RECESSED ADJUSTMENT ELEMENTS
APPAREIL DE COMMUTATION DE SÉCURITÉ POURVU DE COMPOSANTS DE RÉGLAGE ENFONCÉS

(30) Priorität: 25.06.2018 DE 102018115243
(43) Veröffentlichungstag der Anmeldung: 01.01.2020
(73) Patentinhaber: Pilz GmbH & Co. KG, 73760 Ostfildern (DE)
(72) Erfinder: Zinser, Christoph, 73760 Ostfildern (DE); Merz, Lothar, 73760 Ostfildern (DE)
(74) Vertreter: Witte, Weller & Partner Patentanwälte mbB

(56) Entgegenhaltungen:
- DE-U1-202008 001 280
- FR-A1- 2 880 512
- US-A1- 2005 205 282

## Beschreibung

Die vorliegende Erfindung betrifft ein Sicherheitsschaltgerät zum Steuern eines Verbrauchers, insbesondere zum Ein- und sicheren Ausschalten des Verbrauchers, mit mindestens einem Eingang zum Aufnehmen eines Eingangssignals und einem Ausgang zum Ausgeben eines Ausgangssignals sowie mit einer elektrischen Schaltung, welche in Abhängigkeit des Eingangssignals das Ausgangssignal bereitstellt. Ferner betrifft die Erfindung ein Einstellbauelement zum Einstellen eines Betriebsparameters eines solchen Sicherheitsschaltgeräts sowie ein Verfahren zur Herstellung eines solchen Sicherheitsschaltgeräts.

Ein Sicherheitsschaltgerät der eingangs genannten Art ist bspw. aus DE 196 26 129 A1 bekannt.

Gattungsgemäße Sicherheitsschaltgeräte werden vor allem im industriellen Bereich verwendet, um elektrisch angetriebene Maschinen, wie beispielsweise eine Presse oder ein Fräswerkzeug, ein- und sicher auszuschalten. Sie dienen insbesondere in Verbindung mit einem Sicherheitsgeber, beispielsweise einem mechanisch betätigbaren Notaustaster, dazu, die Maschine in einer Notfallsituation schnell und sicher abzuschalten. Hierzu wird beispielsweise die Stromversorgung der abzuschaltenden Maschine über Arbeitskontakte von elektromechanischen Schaltelementen geführt, die von dem Sicherheitsschaltgerät betätigt werden können, um die Stromzufuhr der Maschine zu unterbrechen.

Sicherheitsschaltgeräte werden üblicherweise für eine zentrale Installation und Wartung in einem Schaltschrank untergebracht. Da der Platz in einem Schaltschrank begrenzt ist, ist es erstrebenswert, Sicherheitsschaltgerät möglichst kleinbauend zu realisieren, um möglichst viel Funktion auf geringem Platz unterbringen zu können. Vermehrt wird hierfür auf Sicherheitsschaltgeräte mit elektronischen Schaltelementen zurückgegriffen, die ohne die sonst üblichen Relais der klassischen Relaistechnik auskommen. Durch das Weglassen der sperrigen Relais lassen sich heutzutage Gehäusebreiten für Sicherheitsschaltgeräte von bevorzugt 17,5 mm realisieren.

Indem weitere mechanische oder elektromechanische Bauteile durch elektronische Äquivalente ersetzt werden, ist eine weitere Reduzierung der Gehäusebreite möglich. Zudem kann durch den Fokus auf rein elektronische Elemente der Fertigungsaufwand reduziert werden, insbesondere dann, wenn es möglich ist, sich auf einen einzigen Fertigungsprozess bei der Herstellung der Elektronik, beispielsweise Oberflächenmontagetechnik, einzuschränken. Wünschenswert wäre somit ein Sicherheitsschaltgerät, dessen Schaltung rein aus elektronischen Komponenten, insbesondere SMD-Bauteilen, gefertigt ist.

Es hat sich jedoch gezeigt, dass einige elektromechanische Elemente, die üblicherweise in Sicherheitsschaltgeräten eingesetzt werden, nur schwer oder gar nicht durch rein elektronische Elemente ersetzen lassen, da diese entweder nicht verfügbar sind oder nicht die nötige Stabilität bereitstellen bzw. aus sicherheitstechnischen Aspekten nicht für die Verwendung in Sicherheitsschaltgeräten geeignet sind.

US 2005/205383 A1 zeigt ein elektromechanisches Einstellelement. Das Einstellelement ist auf einer Leiterplatte montierbar, wobei ein Stellglied und Teile des Gehäuses des Einstellelements senkrecht durch eine Aussparung in der Leitplatter hindurchragen.

Vor diesem Hintergrund ist es eine Aufgabe der vorliegenden Erfindung, ein verbessertes Sicherheitsschaltgerät der eingangs genannten Art anzugeben. Insbesondere ist es eine Aufgabe ein Sicherheitsschaltgerät mit geringerer Baugröße, insbesondere mit geringerer Gehäusebreite, anzugeben, das eine vergleichbare Betriebssicherheit und Stabilität gewährt wie herkömmliche Sicherheitsschaltgeräte. Ferner ist es eine Aufgabe ein Sicherheitsschaltgerät anzugeben, dass mit geringerem Fertigungsaufwand produziert werden kann.

Gemäß einem Aspekt der vorliegenden Erfindung wird diese Aufgabe gelöst durch ein Sicherheitsschaltgerät der eingangs genannten Art, wobei die elektrische Schaltung auf einer Leiterplatte angeordnet ist und mit mindestens einem Einstellbauelement zum Einstellen eines Betriebsparameters des Sicherheitsschaltgeräts gekoppelt ist, wobei ferner eine Oberfläche der Leiterplatte eine Montageebene definiert, und wobei das mindestens eine Einstellbauelement ein in einem Gehäuse angeordnetes Stellelement aufweist, das vertieft an der Leiterplatte angeordnet ist, so dass das Gehäuse des Stellelements die Montageebene schneidet, wobei das Stellelement ein Stellglied mit einer Achse aufweist, welche eine Drehachse definiert, die sich parallel zur Montageebene und senkrecht zu einer Frontseite des Gehäuses des Stellelements erstreckt, und wobei die Montageebene die Frontseite schneidet.

Gemäß einem weiteren Aspekt der vorliegenden Erfindung wird diese Aufgabe gelöst durch ein Verfahren zur Herstellung eines Sicherheitsschaltgeräts mit den Schritten:
- Bereitstellen einer Leiterplatte mit mindestens einer Oberfläche, welche eine Montageebene zum Anordnen einer elektrischen Schaltung definiert,
- Bereitstellen eines Einstellbauelements zum Einstellen eines Betriebsparameters des Sicherheitsschaltgeräts, wobei das Einstellbauelement mit der elektrischen Schaltung gekoppelt ist und ein in einem Gehäuse angeordnetes Stellelement aufweist,
- Anordnen der elektrischen Schaltung und des Einstellbauelements, wobei die elektrische Schaltung auf der Oberfläche der Leiterplatte angeordnet wird, und wobei das Einstellbauelement vertieft an der Leiterplatte angeordnet wird, so dass das Gehäuse des Stellelements die Montageebene schneidet,
   wobei das Stellelement ein Stellglied mit einer Achse aufweist, welche eine Drehachse definiert, die sich parallel zur Montageebene und senkrecht zu einer Frontseite des Gehäuses des Stellelements erstreckt, und wobei die Montageebene die Frontseite schneidet.

Gemäß einem noch weiteren Aspekt der vorliegenden Erfindung wird diese Aufgabe auch gelöst durch ein Einstellbauelement zum Einstellen eines Betriebsparameters eines Sicherheitsschaltgeräts, umfassend ein in einem Gehäuse angeordnetes Stellelement, ein Stellglied zum Verstellen des Stellelements, sowie ein vom Gehäuse abstehendes Kontaktelement zum elektrischen Verbinden des Stellelements mit einer elektrischen Schaltung des Sicherheitsschaltgeräts, wobei das Gehäuse einen Körper mit einer Frontseite, einer der Frontseite gegenüberliegenden Rückseite sowie umlaufenden Seitenflächen, welche die Front- und Rückseite voneinander beabstanden, definiert, und wobei das Kontaktelement so ausgebildet ist, dass es mit einem Ende mindestens eine der umlaufenden Seitenflächen kontaktiert und mit einem gegenüberliegenden Ende eine Anschlussfläche bildet, welche bei einer bestimmungsgemäßen Montage des Einstellbauelements eine Montageebene, welche die Front- und Rückseite des Gehäuses schneidet, kontaktiert.

Es ist somit eine Idee der vorliegenden Erfindung, mindestens ein Einstellbauelement der elektrischen Schaltung des Sicherheitsschaltgeräts vertieft in einer Leiterplatte anzuordnen. Vertieft bedeutet dabei, dass ein Gehäuse des Einstellbauelements eine Montageebene, welche durch die Oberfläche der Leiterplatte definiert wird, schneidet. Das Bauteil sitzt somit nicht wie üblich auf der Oberfläche auf, sondern ist vorzugsweise innerhalb einer lochartigen Aussparung in diese versenkt. Vorteilhaft liegt somit eine Unterkante des Bauteils nicht mehr oberhalb der Leiterplatte, sondern bildet die Unterkante des Gesamtaufbaus der elektrischen Schaltung.

Auf diese Weise kann vorteilhaft die Aufbauhöhe der elektrischen Schaltung reduziert werden, selbst wenn anwendungsbedingt größere elektromechanische Bauteile verwendet werden müssen, um die gewohnte Stabilität und Zuverlässigkeit gewährleisten zu können. Durch den vertieften Einbau und die damit verbundene reduzierte Aufbauhöhe kann eine Gehäusebreite um 10% bis 15% verringert werden, wodurch eine bevorzugte Gehäusebreite von 12,5 mm möglich ist.

Durch den vertieften Einbau können zudem Druckkräfte beim Betätigen des Einstellbauelements vorteilhaft abgefangen werden, wodurch Stabilität und Zuverlässigkeit erhöht werden können.

Vorteilhaft können bewährte und erprobte Einstellbauelemente für Sicherheitsschaltgeräte wiederverwendet werden, wobei gleichzeitig eine Reduktion der Gehäusebreite möglich ist. Durch die Wiederverwendung erprobter Bauelemente können Kosten bei der Fertigung eingespart werden. Gleichzeitig kann der Aufwand für eine für sicherheitstechnische Geräte obligatorische Überprüfung und Abnahme neuer Geräte reduziert werden, da interne Prüfungen oder entwicklungsbegleitende Tests entfallen können. Die eingangsgenannte Aufgabe ist damit vollständig gelöst.

In einer bevorzugten Ausgestaltung ist das Einstellbauelement ein Einstellpotentiometer oder Trimmpotentiometer und das Stellelement weist insbesondere ein elektrisches Widerstandsbauelement auf, dessen Widerstandswert mechanisch durch Drehen oder Verschieben veränderbar ist.

Gängige Einstellpotentiometer, die eine ausreichende Stellgenauigkeit aufweisen und ausreichend mechanisch belastbar sind, haben eine Bauhöhe von etwa 10 mm. Es hat sich gezeigt, dass bei gängigen Sicherheitsschaltgeräten, die Bauhöhen der Einstellpotentiometer maßgeblich die Höhe des Gesamtaufbaus der elektrischen Schaltungen bestimmen. Für eine weitere Reduzierung der Bauhöhe müssten die bewährten Einstellpotentiometer daher durch kleinere Bauteile ersetzt werden. Diese sind jedoch entweder gar nicht verfügbar oder weisen nicht die notwendige Stabilität auf, um den mechanischen Belastungen beim Betätigen ausreichend standhalten zu können. Der vertiefte Einbau von Einstellpotentiometern trägt somit besonders vorteilhaft zur Reduzierung der Bauhöhe eines Sicherheitsschaltgerätes unter Beibehaltung der bewährten Stellgenauigkeit und Stabilität bei.

Das Stellelement weist ein Stellglied mit einer Achse auf, welche eine Drehachse definiert, die sich parallel zur Montageebene und senkrecht zu einer Frontseite des Gehäuses des Stellelements erstreckt, wobei die Montageebene die Frontseite schneidet.

Das Stellelement ist somit ein Drehpotentiometer mit einer Welle, über die sich das Stellelement verstellen lässt. Bei gängigen Standard-Drehpotentiometern ist das Stellelement dabei in einem runden oder quaderförmigen Gehäuse angeordnet, aus dem zentral mittig die Welle zum Einstellen herausragt. Dieser Aufbau ermöglicht auf kleinster Fläche eine größtmögliche Stellgenauigkeit und Stabilität des Einstellbauelements. Durch den vertieften Einbau ist es möglich, dass die Welle unmittelbar oberhalb der Leiterplattenoberfläche angeordnet ist bzw. auf diese aufliegt und trotzdem ein Standardstellelement verwendet werden kann, bei dem die Welle zentral mittig aus dem Gehäuse des Stellelements hervorgeht. Somit kann bei reduzierter Bauhöhe auf Standardkomponenten für das Stellelement zurückgegriffen werden, was sich positiv auf die Herstellungskosten auswirkt.

In einer hierzu bevorzugten Ausgestaltung weist das Gehäuse des Stellelements eine der Frontseite gegenüberliegende Rückseite auf, die zumindest teilweise an der Leiterplatte anliegt, um eine Druckbelastung beim Stellen des Stellelements auf die Leiterplatte zu übertragen.

In dieser Ausgestaltung liegt somit das Stellelement mit einer Rückseite an der Leiterplatte zumindest teilweise an. Auf diese Weise können Druckkräfte, welche beim Stellen des Stellelements oder dessen Montage auf das Stellelement wirken, vorteilhaft auf die Leiterplatte übertragen werden. Dies erhöht die Stabilität und vereinfacht vorteilhaft den Montageprozess.

In einer weiteren vorteilhaften Ausgestaltung liegt auch die Frontseite ferner zumindest teilweise an der Leiterplatte an, um eine Zugbelastung beim Stellen des Stellelements auf die Leiterplatte zu übertragen.

In dieser Ausgestaltung ist das Gehäuse des Stellelements somit durch die Leiterplatte wenigstens in zwei zueinander entgegengesetzte Richtungen fixiert. Auf diese Weise kann insbesondere einem "Verschwimmen", d.h. einem Verschieben bei der Montage, vorteilhaft entgegengewirkt werden. Die Montage kann auf diese Weise weiter vereinfacht werden.

In einer weiteren Ausgestaltung weist die Leiterplatte eine Ausfräsung auf, durch welche das Gehäuse des Stellelements steckbar ist.

In dieser Ausgestaltung weist die Leiterplatte somit eine lochartige Aufnahme auf, in die das Gehäuse des Stellelements gesteckt werden kann. Durch eine Leiterplattenausfräsung kann die gewünschte Vertiefung besonders leicht ermöglicht werden. Zudem kann durch eine Ausfräsung der Halt des Bauelements vorteilhaft verbessert werden und eine Luftzirkulation um das Bauteil herum erhöht werden.

In einer weiteren Ausgestaltung weist das Einstellbauelement mindestens ein Kontaktelement auf, welches die elektrische Schaltung auf der Oberfläche kontaktiert.

In diese Ausgestaltung wird das versenkte Bauteil über ein Kontaktelement auf der Oberfläche der Leiterplatte mit der übrigen Schaltung elektrisch verbunden. Bei dem Kontaktelement kann es sich vorteilhaft um Anschlusspins handeln, die wie bei bedrahteten Bauteilen aus dem Gehäuse abstehen, jedoch hier umgebogen sind, um eine Kontaktierung an einer mit der elektrischen Schaltung gemeinsamen Oberfläche zu ermöglichen. Die weiteren Bauteile sind hierbei vorzugsweise in SMD-Technik ausgebildet. Die Ausgestaltung ermöglicht es, dass das versenkte Bauteil wie ein herkömmliches SMD-Bauteil mittels Oberflächenmontagetechnik bestückt und verlötet werden kann. Vorzugsweise wird so ein zusätzlicher Wellenlötvorgang überflüssig und die Herstellung kann auf eine einzige Montagetechnik umgestellt werden. Diese Ausgestaltung trägt somit ebenfalls vorteilhaft zu einem reduzierten Fertigungsaufwand bei.

In einer hierzu bevorzugten Ausgestaltung kontaktiert das mindestens eine Kontaktelement das Gehäuse des Stellelements in einem Abstand zur Montageebene.

In diese Ausgestaltung erfolgt die Kontaktierung am Gehäuse des Stellelements somit nicht auf der Montageebene, sondern vorzugsweise an einer Seitenfläche des Stellelementgehäuses, welche durch den vertieften Einbau versetzt zur Montageebene ist. Dies ermöglicht, dass gängige, einseitig bedrahtete Stellelemente verwendet werden können, bei denen lediglich die Anschlusspins, die üblicherweise durch die Leiterplatte gesteckt werden, hochgebogen sind, um eine Oberflächenmontagetechnik verwenden zu können. Der Rückgriff auf Standardelemente hat, wie bereits zuvor erwähnt, den Vorteil, dass der vertiefte Einbau besonders kostengünstig realisiert werden kann.

In einer weiteren Ausgestaltung weist das Sicherheitsschaltgerät ein Gehäuse mit einer ersten und einer zweiten Seitenfläche auf, die je zur Montageebene parallel verlaufen, wobei das Gehäuse des Stellelements zentral zwischen der ersten und zweiten Seitenfläche angeordnet ist.

In diese Ausgestaltung wird die Gehäusebreite des Sicherheitsschaltgeräts durch zwei Seitenflächen definiert, wobei das Stellelement mittig zwischen den Gehäuseseiten angeordnet ist. Die zentral mittige Anordnung hat den Vorteil, dass bei einer Vielzahl von nebeneinander angeordneten Sicherheitsschaltgeräten eine Zuordnung der Einstellbauelemente zu einem Sicherheitsschaltgerät besser für einen Bediener ersichtlich ist, als bei einer außermittigen Anordnung selbiger. Konfigurationsfehler aufgrund einer Fehlzuordnung können so einfach vermieden werden.

Vorzugsweise ist das Gehäuse des Stellelements in einem gleichen Abstand zu der ersten und zweiten Seitenfläche angeordnet bzw. das Gehäuse liegt an der ersten und zweiten Seitenfläche an. Es kann somit auf gewöhnliche Stellelemente zurückgegriffen werden, die ein rundes oder quaderförmiges Gehäuse haben, aus dem zentralmittig eine Stellkomponente, beispielsweise eine Welle, hervorragt. Auch diese Ausgestaltung trägt somit vorteilhaft dazu bei, dass bei einem vertieften Einbau auf bewährte Standardkomponenten zurückgegriffen werden kann.

Alternativ kann die erste und/oder zweite Seitenfläche auch eine Aussparung aufweisen, in oder durch die sich das Gehäuse des Stellelements erstreckt. Auf diese Weise kann die Mindest-Gehäusebreite bis auf die Bauteilhöhe des Stellelements reduziert werden. Gleichzeitig fixiert und stabilisiert die Aussparung das Stellelement weiter.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine Draufsicht und eine Seitenansicht eines Sicherheitsschaltgeräts gemäß einer Ausführungsform der Erfindung ohne umschließendes Gehäuse,
- Fig. 2: das Ausführungsbeispiel gemäß Fig. 1 samt umschließendem Gehäuse,
- Fig. 3: eine Explosionsdarstellung des Sicherheitsschaltgeräts gemäß den Ausführungsbeispielen nach Fig. 1 und Fig. 2,
- Fig. 4: je eine Frontalansicht dreier Ausführungsbeispiele gemäß einer Ausführungsform der Erfindung,
- Fig. 5: eine perspektivische Darstellung, eine Frontalansicht sowie Drauf- und Seitenansicht eines bevorzugten Einstellbauelements gemäß einer Ausführungsform der Erfindung,
- Fig. 6: eine Leiterplatte gemäß einer bevorzugten Ausführungsform der Erfindung mit T-förmigen Ausfräsungen,
- Fig. 7: eine Leiterplatte gemäß einer weiteren bevorzugten Ausführungsform der Erfindung mit kreuzförmigen Ausfräsungen, und
- Fig. 8: einen Querschnitt eines weiteren bevorzugten Ausführungsbeispiels der vorliegenden Erfindung.

Im Folgenden werden die Figuren im Detail erläutert. Gleiche Bezugszeichen bezeichnen dabei gleiche Teile in allen Zeichnungen und werden nicht für jede Figur im Einzelnen erläutert.

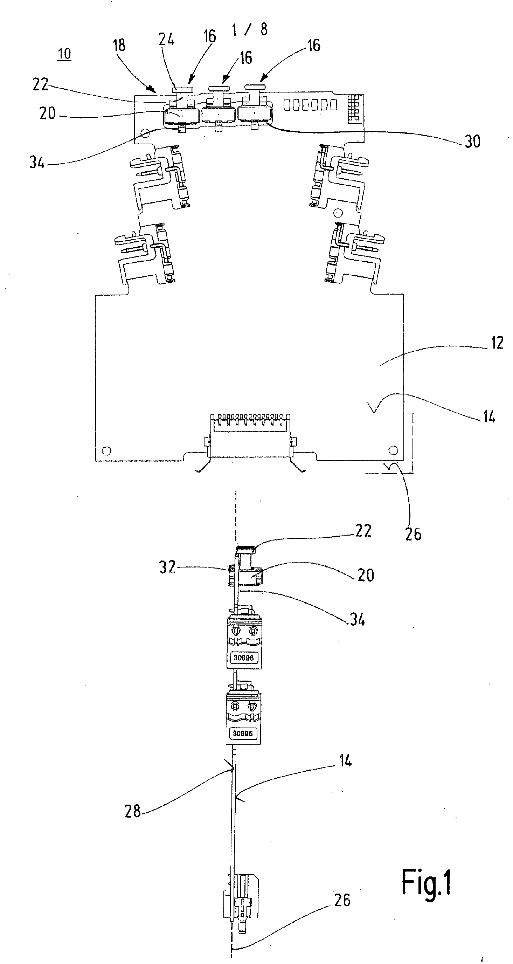

Fig. 1 zeigt eine Draufsicht sowie eine Seitenansicht eines Sicherheitsschaltgeräts gemäß einer Ausführungsform der Erfindung ohne ein umschließendes Gehäuse. In der Fig. 1 ist das Sicherheitsschaltgerät gemäß einer Ausführungsform der Erfindung in seiner Gesamtheit mit der Bezugsziffer 10 bezeichnet.

Das Sicherheitsschaltgerät umfasst eine Leiterplatte 12, auf deren Oberfläche 14 eine elektrische Schaltung angeordnet ist, welche die wesentliche Funktion, d.h. beispielsweise das Ein- und sichere Ausschalten, wahrnimmt und hier der Übersicht halber nicht im Einzelnen dargestellt ist. Die elektrische Schaltung enthält die zum Steuern eines Verbrauchers wesentlichen Elemente und kann insbesondere einen oder mehrere Schaltkreise mit einer Auswerteeinheit, Eingangs- und Ausgangskreisen, sowie mehreren Schaltelementen umfassen.

Vorzugsweise ist die elektrische Schaltung in SMD-Technik realisiert, d.h. sie umfasst im Wesentlichen SMD-Bauteile, die mittels Oberflächenmontage auf der Oberfläche 14 der Leiterplatte 12 angeordnet werden. Im Gegensatz zu Bauelementen der Durchsteckmontage (Englisch: through hole technology, THT) haben SMD-Bauelemente keine Drahtanschlüsse, sondern werden mittels lötfähiger Anschlussflächen direkt auf der Oberfläche 14 der Leiterplatte 12 verlötet. Bei der Oberflächenmontage sind somit die Bauelemente, deren Anschlüsse sowie deren Verbindungen auf derselben Oberfläche 14 der Leiterplatte 12 angeordnet.

Durchsteckmontage und Oberflächenmontage können und werden bei herkömmlichen Sicherheitsschaltgeräten oftmals nacheinander ausgeführt, um eine Leiterplatte für ein Sicherheitsschaltgerät vollständig zu bestücken. Es werden somit üblicherweise zwei Prozessschritte benötigt, um die Leiterplatte zu erstellen. Um den Fertigungsaufwand zu reduzieren, ist es wünschenswert, nur eine Montagetechnologie einsetzen zu müssen, welche hier aufgrund der bevorzugten verringerten Baugröße die Oberflächenmontage mit SMD-Bauteilen ist. Vorzugsweise ist daher die gesamte elektrische Schaltung aus SMD-Bauteilen gebildet.

Eine Ausnahme hiervon bilden bisher die Bauteile zum Einstellen von Betriebsparametern des Sicherheitsschaltgeräts, da diese üblicherweise manuell bedient werden und diese somit bestimmungsgemäß mechanischen Belastungen ausgesetzt sind. Deshalb werden in Sicherheitsschaltgeräten solche Einstellbauelemente üblicherweise als bedrahtete Bauelemente bereitgestellt, da die Durchsteckmontage, also das Einstecken der Verdrahtung in die Leiterplatte, zusätzliche mechanische Stabilität bietet. Neben der mechanischen Stabilität ist bei Einstellbauelementen auch die mechanische Präzision von Bedeutung. Damit ein Einstellbauelement zum Einstellen eines Betriebsparameters für ein Sicherheitsschaltgerät genutzt werden kann, muss beispielsweise durch eine entsprechende Rasterung eine präzise Einstellung jedes einzelnen Zustands möglich sein. Der Aufbau eines Einstellelements ist daher an bestimmte Voraussetzungen geknüpft, die eine Minimalbaugröße des Einstellelements vorgeben. Für robuste und für sicherheitstechnische Anwendungen zulässige Einstellbauelemente hat sich eine Mindestbauhöhe von 10 mm etabliert, wodurch eine minimal realisierbare Gehäusebreite bei herkömmlicher Montage von etwa 17,5 mm erreicht werden kann.

Erfindungsgemäß wird eine alternative Montage solcher Einstellbauelemente vorgeschlagen, die bei gleichbleibender oder sogar erhöhter Stabilität eine geringere Gehäusebreite ermöglicht.

In der Fig. 1 sind drei Einstellbauelemente zum Einstellen eines Betriebsparameters gezeigt und je mit der Bezugsziffer 16 bezeichnet. Die Einstellbauelemente 16 sind in diesem bevorzugten Ausführungsbeispiel Drehpotentiometer oder Drehschalter, über die eine definierte Anzahl an Betriebszuständen des Sicherheitsschaltgeräts einstellbar ist. Vorzugsweise ist hierfür eine mechanische Rasterung vorgegeben, die eine genaue Positionierung bzw. Positionsbeibehaltung der Drehelemente ermöglicht.

Jedes der Einstellbauelemente 16 weist ein Stellglied 18 und ein Stellelement 20 auf. Das Stellglied 18 kann vom Nutzer zum Einstellen bewegt werden und das Stellelement 20 setzt die Einstellbewegung in eine Stellgröße, vorzugsweise eine elektrische Stellgröße, um.

Das Stellglied 18 kann wie hier eine Achse 22 mit einem Drehteller 24 sein, die mit dem Stellelement 20 gekoppelt ist. Das Stellelement 20 ist vorzugsweise ein elektrisches Widerstandsbauelement, dessen Widerstandswerte mechanisch durch Bewegen des Stellglieds 18 veränderbar sind.

Bei dem erfindungsgemäßen Sicherheitsschaltgerät ist das Stellelement 20 vertieft zu einer Montageebene 26 der elektrischen Schaltung angeordnet. Die Montageebene 26 der elektrischen Schaltung wird durch die Oberfläche 14 der Leiterplatte 12 definiert. Vertieft heißt in diesem Zusammenhang, dass ein Gehäuse des Stellelements 20 die Montageebene 26 schneidet und somit bspw. teilweise aus der Rückseite 28 der Leiterplatte 12 hervorsteht. Als Rückseite 28 ist hier die Seite bezeichnet, die der bestückten Oberfläche 14 gegenüberliegt.

Vorzugsweise weist die Leiterplatte 12 für den vertiefen Einbau eine oder mehrere Ausfräsungen 30 auf, durch welche das Stellelement 20 gesteckt wird. Die Baugröße des Stellelements 20 kann somit gegenüber Stellelementen in herkömmlichen Sicherheitsschaltgeräten unverändert bleiben, dennoch kann eine Bauhöhe des Gesamtaufbaus verringert werden, da das Stellelement 20 nicht oberhalb der Oberfläche 14 der Leiterplatte 12 befestigt ist, sondern vielmehr von der Leiterplatte 12 umschlossen wird. Unter Beibehaltung der ursprünglichen Größe und den mechanischen Eigenschaften des Stellelements 20 kann so eine Reduzierung der Gehäusebreite erreicht werden.

Darüber hinaus kann in einer vorteilhaften Ausgestaltung, wie sie in Fig. 1 dargestellt ist, eine Kontaktierung der Einstellbauelemente 16 auf der mit der elektrischen Schaltung bestückten Oberfläche 14 der Leiterplatte 12 erfolgen. Dies wird auf einfache Weise erreicht, indem ein herkömmliches "bedrahtetes" Einstellbauelement verwendet wird, dessen Verdrahtung 32 zum Bauteilkörper hingebogen ist, so dass die freien Enden 34 der Verdrahtung 32 auch in versenkter Position bis auf die Oberfläche 14 der Leiterplatte 12 reichen. Vorteilhaft kann bei dieser Ausgestaltung ein Einstellbauelement 16 wie ein SMD-Bauteil der übrigen elektrischen Schaltung behandelt werden.

Ein vertieft eingebautes Einstellbauelement 16, dessen Verdrahtung 32 so ausgebildet ist, dass diese auf die Oberfläche 14 reicht, kann somit mittels gewöhnlicher Oberflächenmontage zusammen mit den anderen SMD-Bauteilen montiert und verlötet werden. Hierzu werden die freien Enden 34 der Verdrahtung 32 ebenfalls auf lötfähige Anschlussflächen auf der Oberfläche 14 aufgelegt, und auf gleiche Weise wie die anderen Bauteile der elektrischen Schaltung verlötet. Mit anderen Worten kann in einer bevorzugten Ausgestaltung ein sonst üblicherweise verdrahtetes Einstellbauelement wie ein normales SMD-Bauteil im Montageprozess behandelt werden, wodurch sich der Fertigungsaufwand reduzieren lässt, insbesondere wenn auf einen bisher erforderlichen Wellenlötprozess für die Durchsteckmontage vollständig verzichtet werden kann.

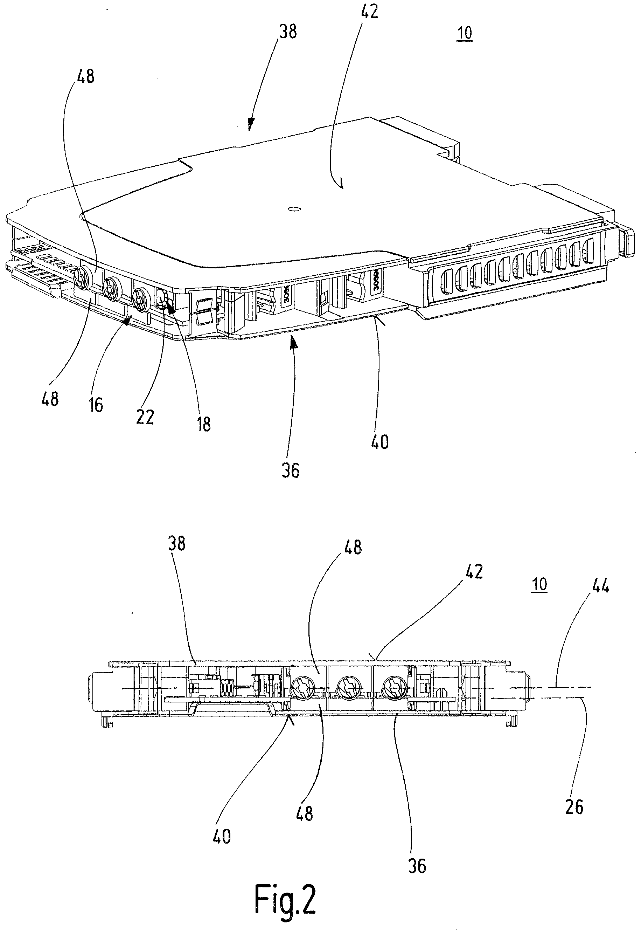

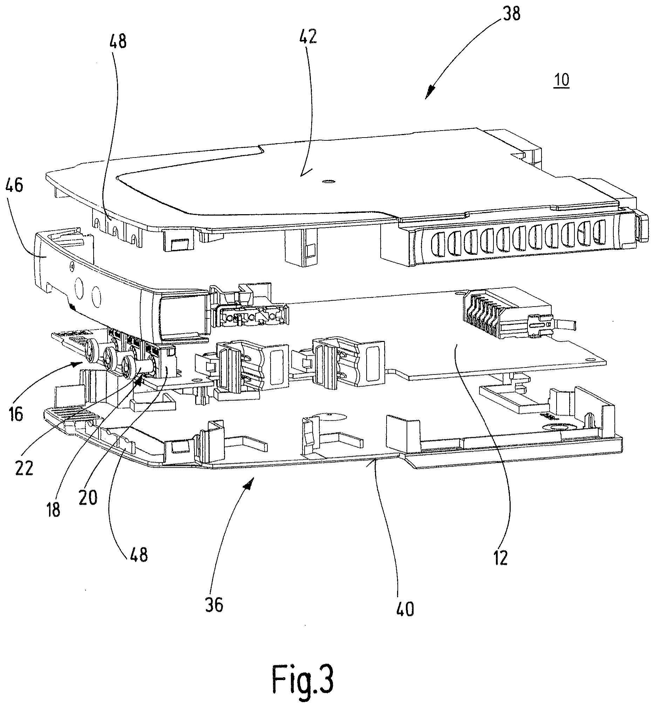

Fig. 2 und Fig. 3 zeigen das vorstehend ausgeführte Ausführungsbeispiel in einer perspektivischen Ansicht, einer Frontalansicht und einer Explosionsdarstellung, jedoch im Unterschied zur Fig. 1 jeweils mit einem umschließenden Gehäuse. Das umschließende Gehäuse weist hier einen ersten und einen zweiten Gehäuseteil 36, 38 auf, zwischen denen die Leiterplatte 12 samt der elektrischen Schaltung angeordnet ist. Die Seitenflächen 40, 42 der beiden Gehäuseteile 36, 38 sind im Wesentlichen parallel zur Montageebene 26 ausgedehnt und Überdecken die Leiterplatte 12 beidseitig.

Die Leiterplatte 12 ist bedingt durch den vorwiegend einseitigen Aufbau der elektrischen Schaltung außermittig zwischen den Gehäuseteilen 36, 38 angeordnet, d.h. die Montageebene 26 steht in einem geringeren Abstand zu der ersten Seitenfläche 40 als zu der zweiten Seitenfläche 42. Eine Einstellebene 44, welche durch die parallelen Achsen 22 der Einstellbauelemente 16 definiert ist, verläuft hingegen vorteilhaft zentral mittig zu den beiden Seitenflächen 40, 42. Diese mittige Ausrichtung der Stellglieder 18 ist vorteilhaft, wenn eine Vielzahl von Schaltgeräten nebeneinander angeordnet ist, da dann eine einfache Zuordnung der Einstellbauelemente 16 zu dem jeweiligen Sicherheitsschaltgerät durch den Nutzer möglich ist und eine Fehlzuordnung, wie sie bei seitlich versetzten Stellgliedern vorkommen kann, vermieden werden kann.

Die Achsen 22 der Einstellbauelemente 16 sind hier räumlich hinter einer Frontplatte 46 angeordnet, so dass die Montage der Komponenten einfach von einer Richtung aus erfolgen kann. Die Montagereihenfolge kann dabei wie folgt sein: Erster Gehäuseteil 36, bestückte Leiterplatte 12 mit Einstellbauelement 16 samt Stellglied 18 und Stellelement 20, Frontplatte 46 und abschließend zweiter Gehäuseteil 38. Um eine Beschädigung der überstehenden Achse 22 während der Montage zu vermeiden, kann die Achse 22 bei der Montage auf dem ersten Gehäuseteil 36 abgestützt werden.

Durch mechanische Anschläge 48 am ersten und/oder zweiten Gehäuseteil 36, 38 kann zudem eine zusätzliche Stabilisierung der Stellglieder 18 erreicht werden. Vorteilhaft können bereits zur Montage die Stellglieder 18 auf einem mechanischen Anschlag des ersten Gehäuseteils 36 aufgelegt werden, um das Einstellbauelement 16 in der vertieften Position für die Montage zu fixieren.

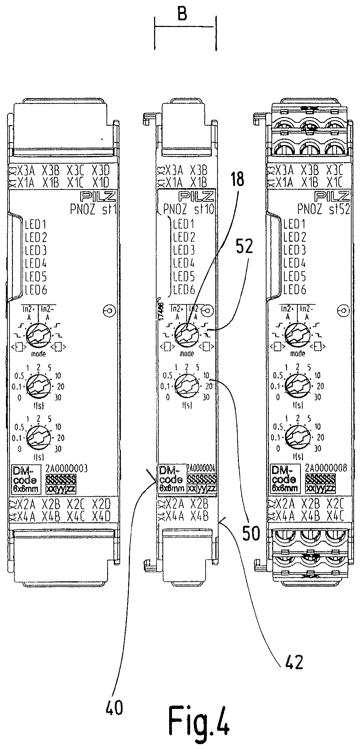

Fig. 4 zeigt jeweils in einer Frontalansicht beispielhaft drei montierte Sicherheitsschaltgeräte mit erfindungsgemäßer Anordnung der Einstellbauelemente. Das mittlere Sicherheitsschaltgerät entspricht dabei einer bevorzugten Ausgestaltung mit einer Gehäusebreite B von 12,5 mm. Die Mittelachse der Stellglieder 18 verläuft hier mittig zwischen den beiden Gehäuseseiten 40, 42 und eine umlaufende Skalenbeschriftung 50 bzw. Anordnung von Symbolen 52 ist möglich.

Selbstverständlich kann eine erfindungsgemäß bestückte Leiterplatte weiterhin auch in breiteren Gehäusen verwendet werden, wie sie hier links und rechts in der Darstellung gezeigt sind. Eine erfindungsgemäß bestückte Leiterplatte ist somit rückwärtskompatibel zu alten Gehäusen, wobei ggf. eine Frontplatte auszutauschen ist.

Bei breiteren Gehäusen kann die erfindungsgemäße Ausgestaltung zudem vorteilhaft sein, da durch eine seitliche Ausrichtung der Mittelachse der Stellglieder mehr Fläche für eine Beschriftung seitlich zu den Stellgliedern zur Verfügung steht.

Es versteht sich, dass die hier dargestellten Sicherheitsschaltgeräte nur exemplarisch zu verstehen sind und andere Ausführungsformen denkbar sind, bei denen die erfindungsgemäß vertiefte Montage zum Einsatz kommt.

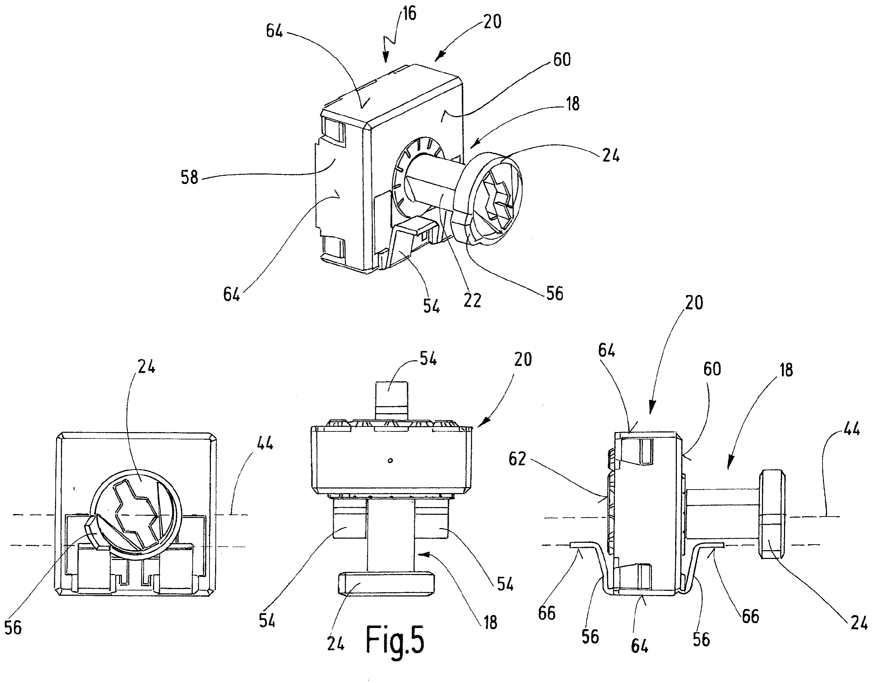

Fig. 5 zeigt ein bevorzugtes Ausführungsbeispiel eines Einstellbauelements 16 in verschiedenen Ansichten.

Das Einstellbauelement 16 ist in dieser Ausführungsform ein Drehpotentiometer mit einem Stellglied 18 und einem Stellelement 20. Das Stellglied 18 ist hier eine zum Stellelement 20 drehbar gelagerte Achse 22 und das Stellelement 20 ein elektrisches Widerstandsbauelement, dessen Widerstandswert mechanisch durch Drehen der Achse 22 veränderbar ist.

Drehpotentiometer dieser Art weisen in der Regel drei Anschlüsse auf, über die das Einstellbauelement 16 mit einer elektrischen Schaltung gekoppelt werden kann. Vorwiegend erfolgt eine Beschaltung als stetig einstellbarer Spannungsteiler. Die Anschlüsse sind in Form von Kontaktelementen 54 realisiert.

Das Einstellbauelement 16 ist als Einstell- bzw. Trimmpotentiometer realisiert, der nur für wenige und meist unkomfortable Verstellungen ausgelegt ist, beispielsweise um eine begrenzte Anzahl von definierten Betriebsparametern eines Sicherheitsschaltgeräts, bspw. bei der Inbetriebnahme, einmalig einzustellen. Das Stellelement 20 verfügt hierzu über eine diskrete Rasterung, wobei jede Raststellung einem definierten Zustand entspricht. Die Rasterung ist dazu ausgelegt, das Stellglied 18 in der jeweiligen Raststellung zu halten, so dass nur durch gezielte Betätigung eine Änderung hervorgerufen wird. Dies kann beispielsweise erreicht werden, indem sich die Achse 22 nur über einen an der Achse angeordneten Drehteller 24 unter Zuhilfenahme eines Schraubenziehers verstellen lässt. Ferner kann ein Überdrehschutz implementiert werden, indem ein zusätzlicher Anschlag 56 an dem Drehteller 24 oder alternativ an der Achse 22 direkt angeordnet ist, der mit einem am Gehäuse befindlichen Anschlag zusammenwirkt und ein Überdrehen der Achse 22 verhindert.

Insbesondere für Sicherheitsschaltgeräte ist es von großer Bedeutung, dass die Rasterung und ein Überdrehschutz zuverlässig und robust ausgestaltet sind, damit durch eine Fehlstellung nicht die Sicherheit gefährdet wird. Wie bereits erwähnt, ist daher eine robuste Mechanik des Einstellbauelements 16 notwendig, wodurch die Auswahl der Größe bzw. Art erheblich einschränkt ist. Trotz der baulichen Einschränkungen wird in der Sicherheitstechnik auf die hier als bevorzugt dargestellten Einstellpotentiometer zurückgegriffen, um den sicherheitstechnischen Vorgaben zu genügen.

Das Stellelement 20 ist in einem Gehäuse 58 angeordnet, in dem hier ein Widerstandselement in Form eines Torus eingekapselt ist. Das Gehäuse 58 ist vorzugsweise quaderförmig mit einer Frontseite 60, einer gegenüberliegenden Rückseite 62 sowie umlaufenden Seitenflächen 64 ausgebildet. Die Seitenflächen 64 beabstanden die Front- und Rückseite 60, 62 voneinander. Die Achse 22 des Stellglieds 18 ragt vorzugsweise, wie hier dargestellt, zentral mittig aus der Frontseite 60 hervor.

Erfindungsgemäß ist das Einstellbauelement 16 ausgebildet, eine elektrische Schaltung auf einer Montageebene 26 zu kontaktieren, welche einen durch das Gehäuse 58 definierten Körper schneidet. D.h. die elektrische Schaltung ist auf einer Ebene montiert, welche die Front- und Rückseite 60, 62 des Gehäuses 58, vorzugsweise in einem rechten Winkel schneidet. So ist es möglich, dass das Einstellbauelement 16 wie zuvor beschrieben versenkt zu einer durch eine Leiterplatte 12 definierte Montageebene 26 angeordnet werden kann.

Wie in Fig. 5 dargestellt, haben die Kontaktelement 54 hierfür einseitig Auflageflächen 66, die so ausgebildet sind, dass sie bei einer Montage auf der Montageebene 26 aufliegen. Darüber hinaus sind die Kontaktelemente 54 mit mindestens einer Seitenfläche der umlaufenden Seitenflächen 64 verbunden, um das elektrische Widerstandsbauelement im Inneren des Gehäuses 58 zu kontaktieren. Diese bevorzugte Ausgestaltung hat den Vorteil, dass das Stellelement 20 gegenüber einer üblichen Kontaktierung nicht verändert werden muss, da auch bei bedrahteten Potentiometern oder SMD-Potentiometern die Kontaktierung gewöhnlich an den Seitenflächen 64 erfolgt. Baulich muss für das erfindungsgemäße Einstellbauelement 16 somit keine Veränderung an dem Stellelement 20 vorgenommen werden. Ein für sicherheitstechnische Anwendung zugelassenes Stellelement 20 kann somit wiederverwendet werden, wodurch sich eine Zulassung des Geräts grundsätzlich vereinfacht.

Vorzugsweise kann ein herkömmliches bedrahtetes Einstellbauelement als Grundlage für die Herstellung des erfindungsgemäßen Einstellbauelements 16 dienen, wobei im Nachgang an dessen Herstellung eine vorhandene Verdrahtung gebogen wird, so dass die Verdrahtung bis zur Montageebene 26 reicht und sich einseitig Anschlussflächen 66 ausbilden. Alternativ können die Kontaktelement 54 auch durch ein angepasstes Stanzwerkzeug entsprechend abgelängt und geformt werden, um die gewünschte Kontaktierung eines ansonsten unveränderten Einstellbauelements zu realisieren.

Besonders vorteilhaft kann das erfindungsgemäße Einstellbauelement 16 mit vormontierter Achse 22 in einem Gurt geliefert und unmittelbar von einer SMD-Bestückungsanlage verarbeitet werden. Ein separates Montieren der Achse kann dabei entfallen. Das Einstellbauelement 16 kann wie jedes andere SMD-Bauteil montiert werden, so dass auf einen für bedrahtete Einstellbauelemente üblicherweise notwendigen Wellenlötprozess vollständig verzichtet werden kann.

Es versteht sich, dass das Gehäuse 58 des Stellelements 20 nicht auf die hier dargestellte Quaderform beschränkt ist, sondern in einem anderen Ausführungsbeispiel bspw. auch rund sein kann. Ebenso sind auch andere Kontaktierungen denkbar, die einen vertieften Einbau ermöglichen.

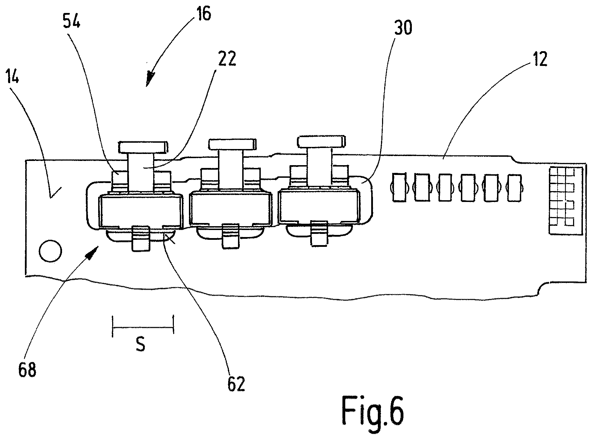

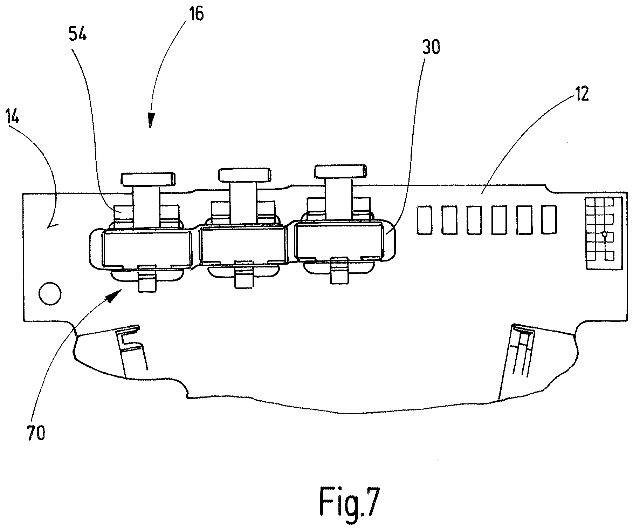

Fig. 6 und 7 zeigen zwei bevorzugte Ausführungsformen von Leiterplatten für den vertieften Einbau, insbesondere für den vertieften Einbau von Einstellbauelementen.

In Fig. 6 und 7 sind je drei Einstellbauelemente 16 der vorbeschriebenen Art in einer gemeinsamen Ausfräsung 30 angeordnet, d.h. die Einstellbauelemente 16 sind durch die Leiterplatte 12 gesteckt und ihre Kontaktelemente 54 liegen einseitig auf einer Oberfläche 14 der Leiterplatte 12 auf.

Die Ausfräsung 30 unterscheidet sich in Fig. 6 und in Fig. 7 durch ihre Kontur.

In Fig. 6 hat die Ausfräsung 30 für ein einzelnes Einstellbauelement 16 eine T-förmige Kontur 68, wobei eine Schaftbreite S so gewählt ist, dass die Rückseite 62 des Einstellbauelements 16 zumindest teilweise an der Leiterplatte 12 anliegt. Eine Druckbelastung auf das Einstellbauelement 16 entlang der Achse 22, wie sie beispielsweise beim Stellen auftreten kann, wird durch das Anliegen der Rückseite 62 vorteilhaft auf die Leiterplatte 12 übertragen. Beschädigungen durch die mechanische Belastung, beispielsweise das Brechen einer Verdrahtung, kann so vorteilhaft vorgebeugt werden. Die Stabilität wird somit insgesamt erhöht.

In der Ausführungsform gemäß Fig. 7 hat die Ausfräsung 30 für ein Einstellbauelement 16 eine kreuzförmige Kontur 70. Ergänzend zur der vorherigen Ausgestaltung gemäß Fig. 6 liegt hierbei somit zusätzlich auch die Frontseite 60 des Einstellbauelements 16 zumindest teilweise an der Leiterplatte 12 an. Dies hat den Vorteil, dass auch eine Zugbelastung entlang der Achse 22 auf die Leiterplatte 12 übertragen werden kann. Gleichzeitig beugt die beidseitige Positionsfixierung einem Verrutschen des Bauteils bei der Montage, insbesondere beim Verlöten der Kontaktelemente, vor. Die Ausführungsform ist daher besonders gut für eine Oberflächenmontage geeignet.

Grundsätzlich bietet eine Ausfräsung 30, egal welcher Form, den Vorteil, dass eine Luftzirkulation um das Einstellbauelement 16 erhöht wird. Dadurch kann das Einstellbauelement 16, welches konstruktionsbedingt regelmäßig eine Verlustleistung umsetzen muss, Wärme besser an die Umgebung abgeben. Die Leiterplatte 12 und benachbarte Bauteile erwärmen sich auch durch die weit auseinanderliegenden Kontaktelemente 54 weniger stark, so dass insgesamt eine höher mögliche elektrische Belastung der Einstellbauelemente 16 bei gegebener Luftzirkulation im Vergleich zur gewöhnlichen Oberflächenmontage oder Durchsteckmontage möglich ist.

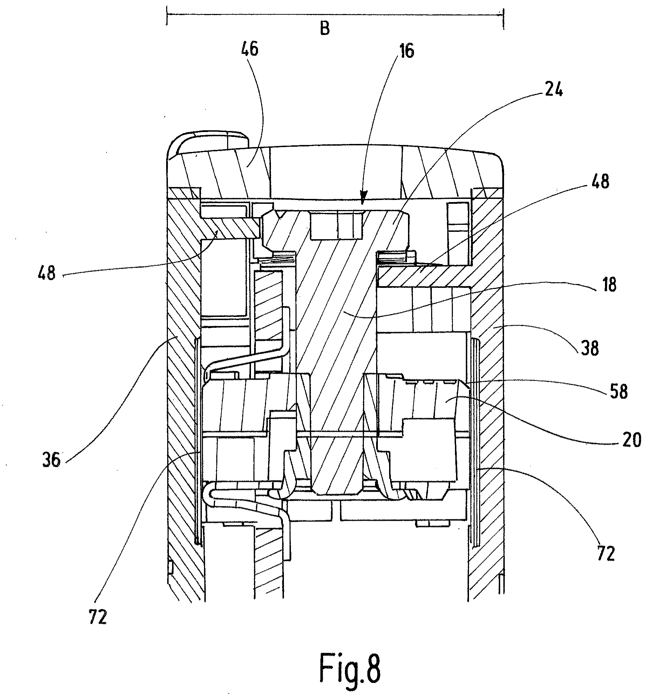

Fig. 8 zeigt abschließend ein bevorzugtes Ausführungsbeispiel, bei dem eine Gehäusebreite weiter reduziert werden kann. Fig. 8 zeigt einen Querschnitt durch ein bevorzugtes Ausführungsbeispiel eines Sicherheitsschaltgeräts und eines der Einstellbauelemente 16. Das Einstellbauelement 16 ist in der zuvor beschriebenen Weise zwischen einem ersten Gehäuseteil 36 und einem zweiten Gehäuseteil 38 platziert.

Der erste und der zweite Gehäuseteil 36, 38 weisen je mechanische Anschläge 48 auf, welche das Stellglied 18 stützen. Einer der mechanischen Anschläge greift dabei am Drehteller 24 an und kann zusammen mit einem am Drehteller 24 vorgesehenen Anschlag einen Überdrehschutz bilden.

Ferner sind in dieser bevorzugten Ausgestaltung zur weiteren Reduzierung der Gehäusebreite in dem ersten und dem zweiten Gehäuseteil 36, 38 Aussparungen 72 vorgesehen, in denen das Gehäuse 58 des Stellelements 20 eingepasst ist. Die Aussparungen 72 können Vertiefungen in den Gehäuseteilen 36, 38 sein oder aber in einem anderen Ausführungsbeispiel Ausfräsungen in Form von Durchbrüchen durch die Gehäuseteile 36, 38 sein. Beide Varianten ermöglichen es, die Gehäusebreite B weiter zu reduzieren, da diese im Wesentlichen von einer Bauhöhe des Gehäuses 58 des Stellelements 20 abhängig ist.

Die Aussparungen 72 tragen zudem zu einer weiteren Fixierung und Stabilisierung der Stellelemente 20 bei. Ebenso können Durchbrüche in den Gehäuseteilen 36, 38 vorteilhaft für eine verbesserte Luftzirkulation sorgen.

Es versteht sich, dass die einzelnen Merkmale der gezeigten Ausführungsformen nicht auf die jeweilige Ausführungsform beschränkt sind, sondern sich mit Merkmalen anderer Ausführungsformen kombinieren lassen.

Ferner wird der Schutzbereich der vorliegenden Erfindung nicht durch die in der Beschreibung erläuterten oder in den Figuren gezeigten Merkmale beschränkt, sondern durch die nachfolgenden Ansprüche bestimmt.

## Patentansprüche

1. Sicherheitsschaltgerät (10) zum Steuern eines Verbrauchers, insbesondere zum Ein- und sicheren Ausschalten des Verbrauchers, mit mindestens einem Eingang zum Aufnehmen eines Eingangssignals und einem Ausgang zum Ausgeben eines Ausgangssignals sowie mit einer elektrischen Schaltung, welche in Abhängigkeit des Eingangssignals das Ausgangssignal bereitstellt,
wobei die elektrische Schaltung auf einer Leiterplatte (12) angeordnet ist und mit mindestens einem Einstellbauelement (16) zum Einstellen eines Betriebsparameters des Sicherheitsschaltgeräts gekoppelt ist,
wobei eine Oberfläche (14) der Leiterplatte (12) eine Montageebene (26) definiert, und
wobei das mindestens eine Einstellbauelement (16) ein in einem Gehäuse (58) angeordnetes Stellelement (20) aufweist, das vertieft an der Leiterplatte (12) angeordnet ist, so dass das Gehäuse (58) des Stellelements (20) die Montageebene (26) schneidet,
**dadurch gekennzeichnet, dass**
das Stellelement (20) ein Stellglied (18) mit einer Achse (22) aufweist, welche eine Drehachse definiert, die sich parallel zur Montageebene (26) und senkrecht zu einer Frontseite (60) des Gehäuses (58) des Stellelements (20) erstreckt, und dass die Montageebene (26) die Frontseite (60) schneidet.

2. Sicherheitsschaltgerät nach Anspruch 1, wobei das Einstellbauelement (16) ein Einstellpotentiometer oder Trimmpotentiometer ist und das Stellelement (20) insbesondere ein elektrisches Widerstandsbauelement aufweist, dessen Widerstandswert mechanisch durch Drehen oder Verschieben veränderbar ist.

3. Sicherheitsschaltgerät nach Anspruch 1, wobei das Gehäuse (58) des Stellelements (20) eine der Frontseite (60) gegenüberliegende Rückseite (62) aufweist, die zumindest teilweise an der Leiterplatte (12) anliegt, um eine Druckbelastung beim Stellen des Stellelements (20) auf die Leiterplatte (12) zu übertragen.

4. Sicherheitsschaltgerät nach einem der Ansprüche 1 bis 3, wobei die Frontseite (60) zumindest teilweise an der Leiterplatte (12) anliegt, um eine Zugbelastung beim Stellen des Stellelements (20) auf die Leiterplatte (12) zu übertragen.

5. Sicherheitsschaltgerät nach einem der Ansprüche 1 bis 4, wobei die Leiterplatte (12) eine Ausfräsung (30) aufweist, durch welche das Gehäuse (58) des Stellelements steckbar ist.

6. Sicherheitsschaltgerät nach einem der Ansprüche 1 bis 5, wobei das Einstellbauelement (16) mindestens ein Kontaktelement (54) aufweist, welches die elektrische Schaltung auf der Oberfläche (14) kontaktiert.

7. Sicherheitsschaltgerät nach Anspruch 6, wobei das mindestens eine Kontaktelement (54) ferner das Gehäuse (58) des Stellelements (20) in einem Abstand zur Montageebene (26) kontaktiert.

8. Sicherheitsschaltgerät nach einem der Ansprüche 1 bis 7, wobei das Sicherheitsschaltgerät ein Gehäuse mit einer ersten (40) und einer zweiten Seitenfläche (42) aufweist, die je zur Montageebene (26) parallel verlaufen, und wobei das Gehäuse (58) des Stellelements (20) zentral zwischen der ersten und zweiten Seitenfläche (40, 42) angeordnet ist.

9. Sicherheitsschaltgerät nach Anspruch 8, wobei das Gehäuse (58) des Stellelements (20) in einem gleichen Abstand zu der ersten und zweiten Seitenfläche (40, 42) angeordnet ist bzw. an der ersten und zweiten Seitenfläche (40, 42) anliegt.

10. Sicherheitsschaltgerät nach Anspruch 9, wobei die erste und/oder die zweite Seitenfläche (40, 42) eine Aussparung (72) aufweist, in oder durch die sich das Gehäuse (58) des Stellelements (20) erstreckt.

11. Einstellbauelement (16) zum Einstellen eines Betriebsparameters eines Sicherheitsschaltgeräts, umfassend ein in einem Gehäuse (58) angeordnetes Stellelement (20), ein Stellglied (18) zum Verstellen des Stellelements (20), sowie ein vom Gehäuse (58) abstehendes Kontaktelement (54) zum elektrischen Verbinden des Stellelements (20) mit einer elektrischen Schaltung des Sicherheitsschaltgeräts, wobei das Gehäuse (58) einen Körper mit einer Frontseite (60), einer der Frontseite gegenüberliegenden Rückseite (62) sowie umlaufenden Seitenflächen (64), welche die Front- und Rückseite (60, 62) voneinander beabstanden, definiert, und wobei das Kontaktelement (54) so ausgebildet ist, dass es mit einem Ende mindestens eine der umlaufenden Seitenflächen (64) kontaktiert und mit einem gegenüberliegenden Ende eine Anschlussfläche (66) bildet, welche bei einer bestimmungsgemäßen Montage des Einstellbauelements (16) eine Montageebene (26), welche die Front- und Rückseite (60, 62) des Gehäuses (58) schneidet, kontaktiert.

12. Verfahren zur Herstellung eines Sicherheitsschaltgeräts mit den Schritten:
- Bereitstellen einer Leiterplatte (12) mit mindestens einer Oberfläche (14), welche eine Montageebene (26) zum Anordnen einer elektrischen Schaltung definiert,
- Bereitstellen eines Einstellbauelements (16) zum Einstellen eines Betriebsparameters des Sicherheitsschaltgeräts, wobei das Einstellbauelement (16) mit der elektrischen Schaltung gekoppelt ist und ein in einem Gehäuse (58) angeordnetes Stellelement (20) aufweist,
- Anordnen der elektrischen Schaltung und des Einstellbauelements (16), wobei die elektrische Schaltung auf der Oberfläche (14) der Leiterplatte (12) angeordnet wird, und wobei das Einstellbauelement (16) vertieft an der Leiterplatte (12) angeordnet wird, so dass das Gehäuse (58) des Stellelements (20) die Montageebene (26) schneidet,
**dadurch gekennzeichnet, dass** das Stellelement (20) ein Stellglied (18) mit einer Achse (22) aufweist, welche eine Drehachse definiert, die sich parallel zur Montageebene (26) und senkrecht zu einer Frontseite (60) des Gehäuses (58) des Stellelements (20) erstreckt, und dass die Montageebene (26) die Frontseite (60) schneidet.

13. Verfahren nach Anspruch 12, wobei das Verfahren ferner umfasst:
- Verlöten der elektrischen Schaltung und des vertieft angeordneten Einstellbauelements, wobei zum Anordnen und Verlöten ausschließlich Oberflächenmontagetechnik eingesetzt wird.

## Claims

1. Safety switching device (10) for controlling a load, in particular for switching the load on and safely off, having at least one input for receiving an input signal and one output for outputting an output signal, and having an electrical circuit which provides the output signal as a function of the input signal,
wherein the electrical circuit is arranged on a printed circuit board (12) and is coupled to at least one setting component (16) for setting an operating parameter of the safety switching device,
wherein a surface (14) of the printed circuit board (12) defines a mounting plane (26), and
wherein the at least one setting component (16) has an adjusting element (20) which is arranged in a housing (58) and is arranged recessed on the printed circuit board (12) so that the housing (58) of the adjusting element (20) intersects the mounting plane (26),
**characterized in that**
the adjusting element (20) comprises an actuator (18) with an axis (22) which defines a rotational axis extending parallel to the mounting plane (26) and perpendicular to a front side (60) of the housing (58) of the actuator (20), and **in that** the mounting plane (26) intersects the front side (60).

2. Safety switching device according to claim 1, wherein the setting component (16) is an adjusting potentiometer or trimming potentiometer and the adjusting element (20) has in particular an electrical resistance component whose resistance value can be changed mechanically by turning or shifting.

3. Safety switching device according to claim 1, wherein the housing (58) of the adjusting element (20) has a rear side (62) that is opposite to the front side (60) and the rear side (62) at least partially abuts against the printed circuit board (12) in order to transfer a pressure load onto the printed circuit board (12), when the adjusting element (20) is operated.

4. Safety switching device according to one of claims 1 to 3, wherein the front side (60) at least partially abuts against the printed circuit board (12) in order to transmit a tensile load onto the printed circuit board (12), when the adjusting element (20) is operated.

5. Safety switching device according to any one of claims 1 to 4, wherein the printed circuit board (12) has a cutout (30) through which the housing (58) of the adjusting element can be inserted.

6. Safety switching device according to any one of claims 1 to 5, wherein the setting component (16) has at least one contact element (54) which contacts the electrical circuit on the surface (14).

7. Safety switching device according to claim 6, wherein the at least one contact element (54) further contacts the housing (58) of the adjusting element (20) at a distance from the mounting plane (26).

8. Safety switching device according to any one of the claims 1 to 7, wherein the safety switching device has a housing with a first (40) and a second side face (42) which each run parallel to the mounting plane (26), and wherein the housing (58) of the adjusting element (20) is arranged centrally between the first and second side face (40, 42).

9. Safety switching device according to claim 8, wherein the housing (58) of the adjusting element (20) is arranged at an equal distance from the first side face (40) and the second side face (42) and abuts against the first and second side faces (40, 42), respectively.

10. Safety switching device according to claim 9, wherein the first side face (40) and/or the second side face (42) has a recess (72) in or through which the housing (58) of the actuator (20) extends.

11. Setting component (16) for adjusting an operating parameter of a safety switching device, comprising an adjusting element (20) arranged in a housing (58), an actuator (18) for adjusting the adjusting element (20), and a contact element (54) projecting from the housing (58) for electrically connecting the adjusting element (20) to an electrical circuit of the safety switching device, wherein the housing (58) defines a body with a front side (60), a rear side (62) opposite the front side, and circumferential side faces (64) which space apart the front and rear sides (60, 62), and wherein the contact element (54) is configured to make contact with at least one of the circumferential side faces (64) at one end and form a terminal surface (66) at an opposite end, the terminal surface (66) making contact with a mounting plane (26) which intersects the front and rear sides (60, 62) of the housing (58), when the setting component (16) is mounted as intended.

12. Method for manufacturing a safety switching device comprising the steps:
- Providing a printed circuit board (12) having at least one surface (14) defining a mounting plane (26) for arranging an electrical circuit;
- Providing a setting component (16) for adjusting an operating parameter of the safety switching device, the setting component (16) being coupled to the electrical circuit and comprising an adjusting element (20) disposed in a housing (58);
- Arranging the electrical circuit and the setting component (16), wherein the electrical circuit is arranged on the surface (14) of the printed circuit board (12), and the setting component (16) is arranged recessed on the printed circuit board (12) so that the housing (58) of the adjusting element (20) intersects the mounting plane (26),
**characterized in that** the adjusting element (20) comprises an actuator (18) with an axis (22) which defines a rotational axis extending parallel to the mounting plane (26) and perpendicular to a front side (60) of the housing (58) of the actuator (20), and **in that** the mounting plane (26) intersects the front side (60).

13. A method according to claim 12, further comprising:
- Soldering the electrical circuit and the recessed setting component, wherein only surface-mounting technology is used for arranging and soldering.

## Revendications

1. Appareil de commutation de sécurité (10) pour commander un récepteur, notamment pour connecter et déconnecter de façon sûre le récepteur, avec au moins une entrée pour recevoir un signal d'entrée et une sortie pour émettre un signal de sortie ainsi qu'avec un circuit électrique qui met à disposition le signal de sortie en fonction du signal d'entrée ;
le circuit électrique étant disposé sur une plaque conductrice (12) et étant couplé à au moins un élément de réglage (16) permettant de régler un paramètre de fonctionnement de l'appareil de commutation de sécurité ;
une surface (14) de la plaque conductrice (12) définissant un plan de montage (26) ; et
l'au moins un élément de réglage (16) comportant un élément de réglage (20) disposé dans un carter (58) qui est disposé de façon enfoncée contre la plaque conductrice (12), de sorte que le carter (58) de l'élément de réglage (20) coupe le plan de montage (26) ;
**caractérisé en ce que** :
l'élément de réglage (20) comporte un maillon de réglage (18) avec un axe (22) qui définit un axe de rotation s'étendant parallèlement au plan de montage (26) et perpendiculairement à un côté avant (60) du carter (58) de l'élément de réglage (20) et que le plan de montage (26) coupe le côté avant (60).

2. Appareil de commutation de sécurité selon la revendication 1, l'élément de réglage (16) comportant un potentiomètre de réglage ou potentiomètre d'équilibrage et l'élément de réglage (20) comportant notamment un composant de résistance électrique dont la valeur de résistance peut être modifiée de façon mécanique par rotation ou coulissement.

3. Appareil de commutation de sécurité selon la revendication 1, le carter (58) de l'élément de réglage (20) comportant un côté arrière (62) opposé au côté avant (60) qui bute au moins en partie contre la plaque conductrice (12) pour transmettre une charge de pression lors de la mise en place de l'élément de réglage (20) sur la plaque conductrice (12).

4. Appareil de commutation de sécurité selon l'une quelconque des revendications 1 à 3, le côté avant (60) butant au moins en partie contre la plaque conductrice (12) pour transmettre une charge de traction lors de la mise en place de l'élément de réglage (20) sur la plaque conductrice (12).

5. Appareil de commutation de sécurité selon l'une quelconque des revendications 1 à 4, la plaque conductrice (12) comportant une fraisure (30) à travers laquelle le carter (58) de l'élément de réglage peut être inséré.

6. Appareil de commutation de sécurité selon l'une quelconque des revendications 1 à 5, l'élément de réglage (16) comportant au moins un élément de contact (54) mettant en contact le circuit électrique sur la surface (14).

7. Appareil de commutation de sécurité selon la revendication 6, l'au moins un élément de contact (54) plaçant en outre le carter (58) de l'élément de réglage (20) à distance du plan de montage (26).

8. Appareil de commutation de sécurité selon l'une quelconque des revendications 1 à 7, l'appareil de commutation de sécurité comportant un carter avec une première (40) et une deuxième surface latérale (42) s'étendant respectivement parallèlement au plan de montage (26) et le carter (58) de l'élément de réglage (20) étant disposé de façon centrale entre la première et la deuxième surface latérale (40, 42).

9. Appareil de commutation de sécurité selon la revendication 8, le carter (58) de l'élément de réglage (20) étant disposé à même distance de la première et de la deuxième surface latérale (40, 42) et/ou butant contre la première et la deuxième surface latérale (40, 42).

10. Appareil de commutation de sécurité selon la revendication 9, la première et/ou la deuxième surface latérale (40, 42) comportant un évidement (72) dans ou à travers lequel le carter (58) de l'élément de réglage (20) s'étend.

11. Élément de réglage (16) pour le réglage d'un paramètre de fonctionnement d'un appareil de commutation de sécurité, comprenant un élément de réglage (20) disposé dans un carter (58), un maillon de réglage (18) pour le réglage de l'élément de réglage (20) ainsi qu'un élément de contact (54) s'écartant du carter (58) pour la liaison électrique de l'élément de réglage (20) avec un circuit électrique de l'appareil de commutation de sécurité, le carter (58) définissant un corps avec un côté avant (60), un côté arrière (62) opposé au côté avant ainsi que des surfaces latérales (64) périphériques maintenant à distance le côté avant et arrière (60, 62) et l'élément de contact (54) étant réalisé de telle sorte qu'il mette en contact avec une extrémité au moins une des surfaces latérales (64) périphériques et forme avec une extrémité opposée une surface de raccordement (66) qui met en contact, en cas de montage conforme à l'usage de l'élément de réglage (16), un plan de montage (26) séparant le côté avant et arrière (60, 62) du carter (58).

12. Procédé de fabrication d'un appareil de commutation de sécurité avec les étapes suivantes :
- mise à disposition d'une plaque conductrice (12) avec au moins une surface (14) définissant un plan de montage (26) pour l'agencement d'un circuit électrique ;
- mise à disposition d'un élément de réglage (16) pour le réglage d'un paramètre de fonctionnement de l'appareil de commutation de sécurité, l'élément de réglage (16) étant couplé au circuit électrique et comportant un élément de réglage (20) disposé dans un carter (58) ;
- agencement du circuit électrique et de l'élément de réglage (16), le circuit électrique étant disposé sur la surface (14) de la plaque conductrice (12) et l'élément de réglage (16) étant disposé de façon enfoncée contre la plaque conductrice (12), de sorte que le carter (58) de l'élément de réglage (20) coupe le plan de montage (26) ;
**caractérisé en ce que** l'élément de réglage (20) comporte un maillon de réglage (18) avec un axe (22) définissant un axe de rotation s'étendant parallèlement au plan de montage (26) et perpendiculairement à un côté avant (60) du carter (58) de l'élément de réglage (20) et que le plan de montage (26) coupe le côté avant (60).

13. Procédé selon la revendication 12, le procédé comprenant en outre :
- la brasure du circuit électrique et de l'élément de réglage disposé de façon enfoncée, sachant que pour l'agencement et la brasure, on utilise exclusivement une technique de montage en surface.
